# NEW EUROPEAN PATENT SPECIFICATION

(11) **EP 1 163 389 B2**
(45) Date of publication and mention of the opposition decision: **16.12.2009**
(45) Mention of the grant of the patent: 21.02.2007
(21) Application number: 99966105.1
(22) Date of filing: 09.12.1999
(51) Int. Cl.: C08K 5/00, H05K 1/02, D06P 3/24, D06P 3/79

(54) **VISIBLE AND FLUORESCENT DYE CONTAINING LAMINATE MATERIALS**
SICHTBARES UND FLUORESZENZFARBSTOFF ENTHALTENDES LAMINAT
MATIERES STRATIFIEES CONTENANT OU COLORANT FLUORESCENT ET VISIBLE

(30) Priority: 11.12.1998 US 111851 P
(43) Date of publication of application: 19.12.2001
(73) Proprietor: Isola USA Corp., Chandler AZ 85226 (US)
(72) Inventor: HEIN, Marc, D., Onalaska, WI 54650 (US); CHOATE, Martin, T., Onalaska, WI 54650 (US); ANDROFF, Nancy, N., W., Burnsville, MN 55306 (US); GOTRO, Jeffrey, T., Trabuco Canyon, CA 92679 (US)
(74) Representative: Müller-Boré & Partner Patentanwälte
(86) International application number: PCT/US1999/029295
(87) International publication number: WO 2000/034566

(56) References cited:
- WO-A1-99/21937
- GB-A- 2 259 410
- US-A- 4 268 610
- US-A- 4 965 208
- US-A- 5 059 580
- US-A- 5 216 479
- US-A- 6 025 017

## Description

### BACKGROUND OF THE INVENTION

This application claims priority to U.S. provisional patent application S.N. 60/111851, filed on December 11, 1998.

### (1) Field of the Invention

This invention concerns polymers useful in manufacturing laminates of a type typical of those used in printed wiring boards. In particular this invention relates to improved polymer formulations which include at least one fluorescent light activated dye and at least one dye visible under ambient light. The use of a combination of dyes enhances automated optical inspection (AOI) of printed wiring boards and other laminates for defects, minimizes the number of errors or false identification of defects by AOI equipment, and enhances the performance of downstream assembly equipment.

### (2) Description of the Art

Automated machinery is frequently used in the electronics industry to inspect finished circuit boards and/or to mount electrical components and chips to laminates to form finished circuit boards. The automated inspection and manufacturing equipment typically includes a camera or some other optical device to view the laminate or printed wiring board in a manner that allows the automated machine to detect flaws in the laminate or partial circuits in a manufactured board.

Some automated optical inspection machines operate by using x-rays, some operate on a principle of visible light reflectance and some operate using fluorescent light. As a result, fluorescent dyes are often added to resins used in laminates and circuit board manufacturing in order to facilitate the use of machines that operate by fluorescence. In addition, resins including dyes visible under ambient light, and especially black dyes, are used to manufacture carriers and housings for integrated circuits and other microchips.

Despite the use of fluorescent inks to facilitate laminate and circuit board inspection and construction, the automated machines used to manufacture and inspect circuit boards that operate by visible light reflectance do not operate well using laminate and printed circuit boards that include fluorescent dyes. In fact, as many as 99% of printed circuit boards inspected by automated machines that operate by reflectance are identified as being defective and must be visibly inspected by humans. Therefore, there is a great need to improve the automated inspectability of circuit board laminate materials.

### SUMMARY OF THE INVENTION

It is an object of this invention to provide a resin composition useful in the manufacture of chip housings, laminates, printed circuit boards and the like, that includes one or more dyes or inks that enhance printed circuit board automated inspectability.

It is another object of this invention to provide circuit boards that include at least one dye that is visible under the ambient light containing layer that improves the inspectability of the circuit board.

It is yet another object of this invention to provide circuit boards including a fluorescent light activated dye and a second dye that is visible under ambient light that allows the circuit board to be inspected by machines that use visible light and/or ultraviolet light to inspect assembled circuit boards.

It is still another object of this invention to provide printed circuit boards manufactured using dye containing resins that are able to be inspected with a high degree of accuracy using fluorescent based automated optical inspection equipment and reflective light automated optical inspection equipment.

Yet another object of this invention to provide printed circuit boards manufactured from dye containing laminate materials that are highly versatile in that they can be inspected and manufactured using reflective light based automated optical inspection equipment, fluorescent light based automated optical inspection equipment or both types of automated optical inspection equipment.

In one embodiment, this invention is a polymer composition of matter that is useful for preparing a laminate wherein the composition includes an organic polymer, and at least one fluorescent light activated dye, and at least one second dye that is visible under ambient light wherein the dyes chosen are compatible with the organic polymer,

It is yet another objection of this invention to provide a composite comprised of a thermosetting resin system that includes at least one fluorescent light activated dye, and at least one second dye that is visible under ambient light.

Still another object of this invention is a printed circuit board that includes at least one layer comprising a composite including at least one organic polymer, at least one dye or ink composition that is visible under natural light, and at least one dye or ink composition that is visible under fluorescent light.

A further object of this invention is a printed circuit board manufacturing method in which the printed circuit board is sequentially inspected by automated optical inspection using two types of automated optical inspection equipment. The method includes providing a plurality of laminates having substantially identical compositions including a resin system, at least one fluorescent light activated dye, and at least one second dye that is visible under ambient light. A first circuit is formed on one side of the metal clad laminate and the first circuit is inspected for defects using ambient light to differentiate between the laminate and the first circuit. A second circuit is formed on the metal clad laminate second side and the second circuit is inspected for defects using fluorescent light to differentiate between the laminate and the second circuit.

The above objects are characterized in the attached Claims.

### DESCRIPTION OF THE CURRENT EMBODIMENT

This invention includes a polymer composition that is useful in the manufacture of laminates, prepegs and other materials that are used in the electronics industry and especially that are useful in the manufacture of laminates. In particular, this invention includes a composition that includes a polymer, a first fluorescent light activated dye and a second dye visible under ambient light, as characterized in the attached claims. The new composition is useful in manufacturing laminates that are subsequently used to manufacture printed circuit boards that are easily inspected and assembled with automated machinery.

For purposes of this invention, the term "dye" and "ink" are used synonymously to refer to compositions, that when added to the polymer composition, alter the color and light transmission properties of products manufactured from the polymer composition. The term "fluorescent light activated dye" is used herein to refer to dyes that are activated and either become visible or change colors when exposed to ultraviolet light. The fluorescent light activated dyes may be invisible to or exhibit one color under ambient light conditions and a second color under fluorescent light conditions. The term "dye visible under ambient light" refers to dyes that impart a color to and/or reduce the transmitability of ambient visible light through materials manufactured using the polymers of this invention. The dyes that are visible under ambient light that are used herein may also be activated by fluorescent light. The dyes that are useful in the compositions and products of this invention are those that do not effect polymer processability, reactivity or end product properties that are colorfast, that do not migrate when the polymer is used to manufacture solid products, that are stable in the resin or varnish composition long enough to provide a shelf life of several weeks, and that do not fade over time. One class of preferred dyes that are useful in the compositions of this invention are solvent based dyes. Solvent dyes are defined as dyes that are soluble in organic solvents. These dyes are based on a wide variety of chemistries ranging from anthraquinones, phthallocyanines, diphenyl methane (for blue), and azine based dyes for blacks. Black dyes may also be obtained through blending of other colors, for example yellow, red, violet (pyraziene, azo, and anthraquinones). A black dye that is especially useful in this application is an azo based solvent dye having the following formula: 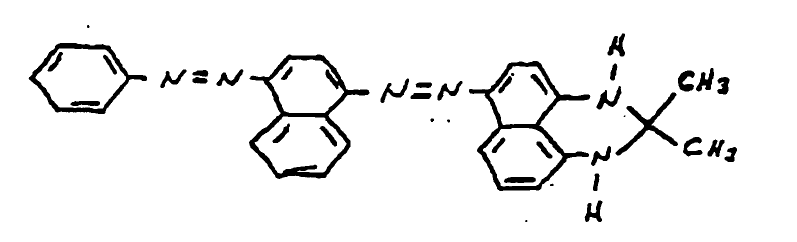 Other classes of preferred dyes include nitrogen containing dyes, highly aromatic dyes, and highly aromatic nitrogen containing dyes.

The dyes should be present in the compositions and products of this invention in an amount sufficient to enhance the ability of automated optical inspection machines that process the laminate products to recognize flaws and defects in the materials as well as to recognize non-polymer components of products such as circuit traces in a printed circuit board. Thus, the dyes or inks of this invention are present in the polymer compositions of this invention in an amount ranging from about 0.01 to about 10.0 wt % and more preferably in a range of from about 0.01 to about 5.0 wt %. It is most preferred that the fluorescent light activated dye and the second dye that is visible under ambient light are each present in the polymer compositions of this invention in an amount ranging from about 0.01 to about 2.0 wt %.

The total amount of fluorescent light activated dye in the compositions of this invention will vary based, in part, on the amount of the second dye that is visible under ambient light used in the compositions. Generally, the second dye will tend to mask the effectiveness of the fluorescent light activated dye in the composition. Therefore, it is preferred that the compositions of this invention include a fluorescent light activated dyes in an amount sufficient to overcome any masking effect of the second ambient light visible dyes in order to produce laminates that exhibit acceptable fluorescence.

The polymer compositions useful in this invention consist of any thermoset resins such as, but not limited to epoxy, cyanate ester, polyimide, bismaleimide triazine, novolacs, or urethane resin systems. Other compositions useful in this invention may also include blends of thermoset resins with one or more thermoplastic resins such, but not limited to styrene-maleic anhydride copolymers, polyphenylene oxides, polyamides, thermoplastic urethanes, nitrile rubbers, butadiene rubbers and silicone. The polymer, when combined with one or more dyes may be formed by curing into solid materials, or they may be combined with or impregnated upon support materials such as woven or non-woven cloths or fibers such as fiberglass, E-glass, quartz, paper, aramid, PTFE, CCP or similar reinforcing materials.

The dyes are preferably incorporated into a "resin system". The resin system will typically consist of at least one polymer as well as other materials that are necessary to provide the appropriate strength, durability, heat resistance, water resistance and so forth to the materials manufactured from the polymer system. Some examples of resin system components include, chain extenders, curing agents, catalysts, reactivity controllers and so forth. Examples of resin systems useful in conjunction with the dyes as described in U.S. Patent Nos. 5,508,328, 5,620,789, 5,534,565 and U.S. Provisional Application Serial No. 60/019,853 each of which are incorporated herein by reference. Another resin system example is set forth in PCT/EP97/05308 which is also incorporated herein by reference.

The dye containing polymers and resin systems of this invention are useful in preparing prepegs, metal clad laminates, unclad laminates, housings and other substrates that are useful in the manufacture of electronic circuits, integrated circuit housings, and so forth. Prepregs and laminates are most often produced on machines called treaters. The treaters typically include feed rollers, a resin impregnation tank, a treater oven, and receiver rollers. If used, a reinforcing material such as glass fibers is usually supplied from a large spool. The spool is put on the feeder rollers which turn and slowly roll off the glass. The glass then moves through the dye containing resin system in a resin impregnation tank. After emerging from the tank, the dye containing resin impregnated glass moves upwards at speeds ranging from 10 to 100 feet per minute to a treater oven which is typically operates at about 200-300°F. At the base of the treater oven is a set of rollers that the impregnated glass passes between. The gap setting between the two rollers determines the amount of resin that will be coated onto the glass. In the treater, the resin wets the glass and solvent in the resin is boiled away at which point the resin begins to polymerize. When the material emerges from the tower it is cured to an extent that is not wet or tacky. However, the cure process is typically stopped short of completion so that additional curing can occur when the final laminate is made. The laminate then may be associated with one or more metal sheets of conductive metal clad laminates. A preferred metal cladding is copper. The metal clad laminates may then be processed using conventional circuit board processing techniques to apply circuit traces to the laminate surfaces. In addition, the circuit board layers may be laminated if desired to form multilevel circuit boards.

The metal clad laminates manufactured using the dye containing compounds of this invention are easily manufactured into printed circuit boards that may then be easily evaluated and manufactured using automated optical inspection equipment. One primary advantage of circuit boards manufactured using these metal clad laminates is that they may be inspected using automated optical inspection equipment that operates on visible light reflectance principles or that operates using fluorescent light.

Thus a manufacturer can stock a plurality of laminates having substantially identical compositions, and sell a first one of the laminates to a first board shop and a second one of the laminates to a second board shop. The first board shop can form a first circuit on the first laminate and the first circuit may be inspected for defects using ambient light sensitive automated optical inspection equipment to differentiate between the first circuit and the dye containing laminate. The second board shop can form a second circuit on the second laminate and the second circuit may be inspected for defects using fluorescent light sensitive automated optical inspection equipment to differentiate between the second circuit and the dye-containing laminate. The use of two dyes in the laminate allows for a high degree of versatility in circuit board automated optical inspection. The preferred dyes are of a color that is distinguishable from the circuit traces using either the fluorescent or reflective light equipment.

### EXAMPLE 1

This Example discloses a resin system that is useful for manufacturing a metal clad laminate material that includes a black solvent based dye that is visible under ambient light and a dye that is activated by fluorescent light. The resin system used is set forth in Table 1 below:

**Table 1**

| **Dye Containing Resin Composition** | | | | |
|---|---|---|---|---|
| **Ingredient** | **Trade Name** | **Manufacturer** | **Kg** | **Order of Addition** |
| Epoxy resin system | UR-X19081 | Dow | 36.69 | 3 |
| Methanol | | - | 0.333 | 6 |
| Boric Acid | | - | 0.20 | 6 |
| Accelerator | Curimid 2,4 EMT | Boergaard Synthesis | 0.30 | 6 |
| Solvent based fluorescent ink | Uvitex OB | CIBA | 0.20 | 6 |
| Styrene Malic Anhydride | ER-30 | ELF Autochem | 26.18 | 4 |
| Toughening Modifier | PKHS-40 | Phenoxy Associates | 8.77 | 5 |
| Methyl Ethyl Ketone | - | - | 8.04 | 2 |
| Cyclohexanone or DMF | - | - | 19.52 | 1 |
| Solvent based black ink-ambient light visible | Neptune Blk X-60 | Aakash Chemicals and Dyesuffs | 0.39 | 7 |
| Total | | | 100 | |

The resin formulation of Table 1 was used to prepare a laminate for subsequent use as an integrated circuit carrier. The resin varnish is mixed in a suitably sized metal, glass or plastic mixing vessel at ambient temperature. SMA and PKHS-40 are pre-dissolved in 70:30 cyclohexanone/MEK or 100% DMF at 50% and 40% solids respectively. The SMA solution and epoxy are combined followed by the cyclohexanone solution and mixed for several hours using a high shear cowels type blade mixers. After reaching homogeneity, the accelerator, boric acid and Uvitex OB, dispersed in methanol, are added. The mixture is allowed to digest 24 hours with mixing. The dye is typically added after addition of the methanol solution but may be dissolved at any step.

### Prepreg

The resin varnish then "prepregged" or spread onto woven glass at a loading range of from 30 to 80% by weight dried varnish using the process described in the paragraph spanning pages 10-11. The treater process, in addition to doubling the percent resin content of the prepreg, also controls advancement of a resin system or "B-stages" of the material to a customer specified press flow expressed as a percentage of resin movement away from the substrate during press curing.

### Laminate

The B-staged prepreg is laid up in a customer specified stack configuration with copper and/or release films in the case of clad laminate and release film only in the case of unclad laminate. In a typical cure cycle, the stack is maintained at a pressure of about 200 psi and under a vacuum of about 30 in/Hg. The stack temperature is raised from about 180°F to about 375°F over a period of 20 minutes. The stack remains at a temperature of about 375°F for 75 minutes after which the stack is cooled from a temperature of 375°F to a temperature to 75°F over a 20 minute period.

### EXAMPLE 2

Example 2 discloses a resin system including a fluorescent light activated dye as well as a blue ambient light visible dye. The blue dye used has the following formula: 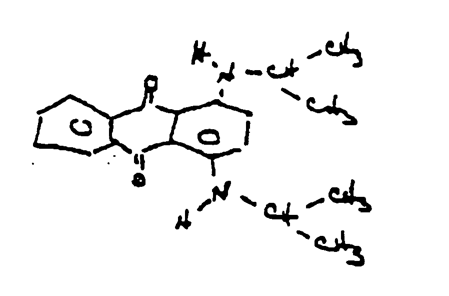 The resin system was used to manufacture metal clad laminates. The resin system used is set forth in Table 2 below.

**Table 2**

| **Dye Containing Resin Composition** | | | |
|---|---|---|---|
| **Component** | **Trade Name** | **Manufacturer** | **Amount wt %** |
| Epoxy resin | DER 592-480 | Dow | 75.4 |
| Dicyandiamide | - | - | 1.89 |
| Z:methyl imidazole | - | - | 0.211 |
| Boric acid | - | - | |
| Epoxy resin containing Fluorescent Dye agent | EPON 1031-A70 | Shell | 3.50 |
| Dimethylformamide | - | - | 18.6 |
| Visible blue dye | Solvent blue 36 | Aakash Chemicals and Dyestuffs | 0.155 |

A laminate was prepared using the resin composition in Table 2 by applying the formulation to a coated welding glass fabric. The resin coated fabric was held at the temperature of about 350°C for about 5 minutes to achieve B-stage and then cured to C-stage by pressing at 350 °C for about 1.5 hours to produce a laminate. The copper foil was applied to both surfaces of the laminate during pressing to produce a copper clad laminate.

The copper clad laminate was etched by convention techniques to apply a circuit structure to the laminate surface. AOI machines that operated on the principle of visible light reflectance-and-fluorescence were used to evaluate the inspectability of the blue dyed laminate. The reflective AOI machines used were manufactured by Orbotech and by Lloyd-Doyle. The fluorescent AOI machine used was the Orbotech 309. The AOI units tested could each locate fiducials at post-etch punch, and the laminates punched acceptably. Furthermore, the AOI unit could inspect each panel and the AOI unit was not sensitive to laminate imperfections. The blue dye material provided enough contrast for proper panel identification in downstream manufacturing machines.

### EXAMPLE 3

The resin system of Example 1 was used to manufacture a metal clad laminate according to the Example 2 that was subsequently subjected to AOI inspectability tests using the AOI machines identified in Example 2. The difference between the compositions of Example 2 and Example 1 lie primarily in the use of a black solvent based dye in Example 1 as opposed to a blue solvent based dye in Example 2. Upon inspection by the AOI units, the laminate prepared from the dye containing resin system of Example 1 was found to be inspectable. However, the AOI units were very sensitive to the resin surface and identified imperfections and scratches in the laminate surface as flaws. Furthermore, using a black dyed laminate causes the circuit board circuit to become invisible when black oxide was applied to the circuit traces. This problem can be overcome by applying a brown or white oxide to the circuit trace surface in order to maintain a good contrast between the circuit traces and circuit board laminate material.

### EXAMPLE 4

The purpose of this Example was to evaluate the ability of automated on-line inspection equipment to evaluate defects in laminates including light blue, dark blue and black dyes versus yellow control. In order to evaluate the dyes, ten inner layers were prepared using each of the three dye materials and the control material. The inner layers were prepared by standard processing techniques. The control inner layer was manufactured using a functional resin including a yellow dye contaminant. The dye containing inner layers were manufactured using a resin including 0.5 wt% black dye or 0.25 or 0.5 wt% blue dyes. Identical circuits were applied to both layers of each of the inner layers using standard fabrication techniques. A single AOI mission, using a Lloyd Doyle AOI machine was used to evaluate each of the inner layers.

The control group of 10 inner layers was inspected first using the Lloyd Doyle AOI machine and the number of hits detected by the AOI machine was recorded. Next, the control group was manually inspected to record the number of real defects identified by the AOI machine versus false defects. The evaluation of the 10 inner layers manufactured with each dye containing resin was performed in a similar manner. The AOI machine was then adjusted and the non-control inner layers were evaluated a second time using the AOI machine. The results of the AOI evaluation are set forth in Table 3 below:

**Table 3**

| **Part** | **# of Hits** | **Cu Splash** | **Contrast** | **False Hits** | **Dirt** | **Oxidation** | **Defects** | **Mask** |
|---|---|---|---|---|---|---|---|---|
| Yellow | 362 | 7 | 189 | 68 | 75 | 6 | 3 | 16 |
| BI-25 | 216 | 9 | 2 | 100 | 85 | 7 | 9 | 1 |
| BI-50 | 223 | 6 | 0 | 82 | 106 | 12 | 14 | 1 |
| Black | 198 | 9 | 16 | 13 | 158 | 1 | 3 | 0 |

Each column above represents the total of inspections of two sides of ten cores of each inner layer color for a total of twenty sides of each color. In Table 3 above, "# of Hits" refers the total number of defects that the AOI scanner detected. "Cu Splash" refers to the number of excess copper defects. "Contrast" refers to false hits due to interpreting opposite side copper features as defects. "False Hits" refers to situations when an Orbotech verifier moved to the area where a defect (i.e. copper splash) should be, but no defect was seen visually. It is probable that most false hits resulted from dirt on the inner layer surface that was present during AOI but eliminated before verification. "Dirt" refers to circumstances where the operator at the verifier physically swiped their hand over the core to remove a dirt particle. "Oxidation" refers to situations where the operator needed to use an eraser to clean off the circuit/pad. "Defects" refer to real defects that need not be detected by the scanners, and "Mask" refers to possible defects that were detected but that were not near the circuitry image. The results show that the number of materials that can cause false hits can be greatly reduced by changing the color of the base laminate from yellow control to blue or black. The blue and black dyes especially improve contrast false hits.

## Claims

1. A composition of matter comprising;
a thermosetting resin system;
at least one fluorescent light activated dye; and
at least one second dye that is visible under ambient light,
wherein the fluorescent light activated dye is present in the composition in an amount ranging from about 0.01 to about 10.0 wt%

2. The composition of matter of claim 1 wherein the second dye is present in the composition in an amount ranging from about 0.01 to about 5.0 wt%

3. The composition of matter of claim 1 wherein the fluorescent light activated dye and the second dye are each solvent based dyes.

4. The composition of matter of claim 1 wherein the fluorescent light activated dye and the second dye are each present in the composition in an amount ranging from about 0.01 to about 2.0 wt%.

5. The composition of matter of claim 1 wherein the second dye is a solvent based dye includes at least one dye that is selected from the group of colors consisting of green, red, brown, black, blue, and violet.

6. A laminate comprising a cured resin wherein the laminate includes at least one fluorescent light activated dye present in an amount ranging from about 0.01 to about 10.0 wt%, and at least one second dye that is visible under ambient light.

7. The laminate of claim 6 including a reinforcing material.

8. A circuit board including at least one layer comprising a cured resin including at least one fluorescent light activated dye present in an amount ranging from about 0.01 to about 10.0 wt%, and at least one second dye that is visible under ambient light

9. A method of simplifying the manufacture of printed circuit boards, comprising the steps of:
(a) providing a plurality of laminates having substantially identical compositions, each such laminate including a thermosetting resin system, at least one fluorescent light activated dye and.at least one second dye that is visible under ambient light:
(b) forming a first circuit on a first one of said laminates and inspecting said first circuit for defects using ambient light to differentiate between said laminate and said first circuit; and
(c) forming a second circuit on a second one of said laminates and inspecting said second circuit for defects using fluorescent light to differentiate between said laminate and second circuit

10. The method of claim 9 wherein the fluorescent light activated dye is present in the laminates in an amount ranging from about 0.01 to about 10.0 wt%

11. The method of claim 9 wherein the second dye is present in the laminates in an amount ranging from about 0.01 to about 5.0 wt%

12. The method of claim 9 wherein the fluorescent light activated dye and the second dye are each solvent based dyes.

13. The method of claim 9 wherein the fluorescent light activated dye and the second dye are each present in the laminates in an amount ranging from about 0.01 to about 2.0 wt%.

14. The method of claim 9 wherein the second dye is a solvent based dye including at least one dye that is selected from the group of colors consisting of green, red, brown, black, blue, and violet.

15. The method of claim 9 wherein the laminates include a reinforcing material.

## Patentansprüche

1. Materialzusammensetzung, umfassend:
ein wärmehärtbares Harzsystem;
mindestens einen durch Fluoreszenzlicht aktivierten Farbstoff; und
mindestens einen zweiten Farbstoff, welcher bei Umgebungslicht sichtbar ist, worin der durch Fluoreszenzlicht aktivierte Farbstoff in der Zusammensetzung in einer Menge im Bereich von ungefähr 0,01 bis ungefähr 10,0 Gew.-% vorliegt.

2. Materialzusammensetzung nach Anspruch 1, worin der zweite Farbstoff in der Zusammensetzung in einer Menge im Bereich von ungefähr 0,01 bis ungefähr 5,0 Gew.-% vorliegt.

3. Materialzusammensetzung nach Anspruch 1, worin der durch Fluoreszenzlicht aktivierte Farbstoff und der zweite Farbstoff jeweils lösungsmittelbasierte Farbstoffe darstellen.

4. Materialzusammensetzung nach Anspruch 1, worin der durch Fluoreszenzlicht aktivierte Farbstoff und der zweite Farbstoff in der Zusammensetzung jeweils in einer Menge im Bereich von ungefähr 0,01 bis ungefähr 2,0 Gew.-% vorliegen.

5. Materialzusammensetzung nach Anspruch 1, worin der zweite Farbstoff ein lösungsmittelbasierter Farbstoff ist und mindestens einen Farbstoff einschließt, welcher ausgewählt ist aus der Gruppe von Farben, bestehend aus grün, rot, braun, schwarz, blau und violett.

6. Laminat, umfassend ein gehärtetes Harz, worin das Laminat mindestens einen durch Fluoreszenzlicht aktivierten Farbstoff, welcher in einer Menge im Bereich von ungefähr 0,01 bis ungefähr 10,0 Gew.-% vorliegt, und mindestens einen zweiten Farbstoff, welcher bei Umgebungslicht sichtbar ist, enthält.

7. Laminat nach Anspruch 6, welches ein Verstärkungsmaterial enthält.

8. Leiterplatte, die mindestens eine Schicht enthält, welche ein gehärtetes Harz umfasst, das mindestens einen durch Fluoreszenzlicht aktivierten Farbstoff, welcher in einer Menge im Bereich von ungefähr 0,01 bis ungefähr 10,0 Gew.-% vorliegt, und mindestens einen zweiten Farbstoff, welcher unter Umgebungslicht sichtbar ist, enthält.

9. Verfahren zur Vereinfachung der Herstellung von gedruckten Leiterplatten, umfassend die Schritte:
(a) Vorsehen einer Vielzahl von Laminaten mit im Wesentlichen identischen Zusammensetzungen, wobei ein jedes Laminat ein wärmehärtbares Harzsystem, mindestens einen durch Fluoreszenzlicht aktivierten Farbstoff und mindestens einen zweiten Farbstoff, welcher unter Umgebungslicht sichtbar ist, enthält;
(b) Bilden einer ersten Schaltung auf einem ersten dieser Laminate und Betrachten der ersten Schaltung hinsichtlich Defekten unter Verwendung von Umgebungslicht zur Unterscheidung zwischen dem Laminat und der ersten Schaltung; und
(c) Bilden einer zweiten Schaltung auf einem zweiten dieser Laminate und Betrachten der zweiten Schaltung hinsichtlich Defekten unter Verwendung von Fluoreszenzlicht zur Unterscheidung zwischen dem Laminat und der zweiten Schaltung.

10. Verfahren nach Anspruch 9, worin der durch Fluoreszenzlicht aktivierte Farbstoff in den Laminaten in einer Menge im Bereich von ungefähr 0,01 bis ungefähr 10,0 Gew.-% vorliegt.

11. Verfahren nach Anspruch 9, worin der zweite Farbstoff in den Laminaten in einer Menge im Bereich von ungefähr 0,01 bis ungefähr 5,0 Gew.-% vorliegt.

12. Verfahren nach Anspruch 9, worin der durch Fluoreszenzlicht aktivierte Farbstoff und der zweite Farbstoff jeweils lösungsmittelbasierte Farbstoffe darstellen.

13. Verfahren nach Anspruch 9, worin der durch Fluoreszenzlicht aktivierte Farbstoff und der zweite Farbstoff jeweils in den Laminaten in einer Menge im Bereich von ungefähr 0,01 bis ungefähr 2,0 Gew.-% vorliegen.

14. Verfahren nach Anspruch 9, worin der zweite Farbstoff ein lösungsmittelbasierter Farbstoff ist, welcher mindestens einen Farbstoff einschließt, welcher ausgewählt ist aus der Gruppe von Farben, bestehend aus grün, rot, braun, schwarz, blau und violett.

15. Verfahren nach Anspruch 9, worin die Laminate ein Verstärkungsmaterial enthalten.

## Revendications

1. Composition de matière comprenant : un système de résine thermodurcissable ;
au moins un colorant activé à la lumière de fluorescence ; et
au moins un deuxième colorant qui est visible à la lumière ambiante,
dans laquelle le colorant activé à la lumière de fluorescence, est présent dans la composition en une quantité variant d'environ 0,01 à environ 10,0 % en poids.

2. La composition de matière de la revendication 1, dans laquelle le deuxième colorant est présent dans la composition en une quantité variant d'environ 0,01. à environ 5,0 % en poids.

3. La composition de matière selon la revendication 1, dans laquelle le colorant activé à la lumière de fluorescence, et le deuxième colorant sont chacun des colorants pour solvant.

4. La composition de matière de la revendication 1, dans laquelle le colorant activé à la lumière de fluorescence, et le deuxième colorant sont présents chacun dans la composition en une quantité variant d'environ 0,01 à environ 2,0 % en poids.

5. La composition de matière de la revendication 1, dans laquelle le deuxième colorant est un colorant pour solvant qui comprend au moins un colorant choisi parmi le groupe des couleurs vert, rouge, marron, noir, bleu et violet.

6. Stratifié comprenant une résine durcie, dans lequel le stratifié comprend au moins un colorant activé à la lumière de fluorescence présent en une quantité allant d'environ 0,01 % à environ 10,0 % en poids, et au moins un deuxième colorant qui est visible à la lumière ambiante.

7. Le stratifié de la revendication 6, comprenant un matériau de renforcement.

8. Plaque à circuit comprenant au moins une couche contenant une résine durcie comprenant au moins un colorant activé à la lumière de fluorescence présent en une quantité allant d'environ 0,01 % à environ 10,0 % en poids, et au moins un deuxième colorant qui est visible à la lumière ambiante.

9. Procédé de simplification de la fabrication de plaques à circuit imprimé, comprenant les étapes consistant à :
(a) fournir plusieurs stratifiés ayant des compositions à peu près identiques, chacun de ces stratifiés, comprenant un système de résine thermodurcissable, au moins un colorant activé à la lumière de fluorescence, et au moins un deuxième colorant qui est visible à la lumière ambiante ;
(b) former un premier circuit sur un premier des dits stratifiés, et contrôler ledit premier circuit pour les défauts en employant la lumière ambiante pour différencier ledit stratifié et ledit premier circuit ; et
(c) former un deuxième circuit sur un deuxième des dits stratifiés, et contrôler ledit deuxième circuit pour les défauts en employant de la lumière de fluorescence pour différencier ledit stratifié et le deuxième circuit.

10. Le procédé de la revendication 9, dans lequel le colorant activé à la lumière de fluorescence, est présent dans les stratifiés selon une quantité variant d'environ 0,01 à environ 10,0 % en poids.

11. Le procédé de la revendication 9, dans lequel le deuxième colorant est présent dans les stratifiés selon une quantité variant d'environ 0,01 à environ 5,0 % en poids.

12. Le procédé de la revendication 9, dans lequel le colorant activé à la lumière de fluorescence, et le deuxième colorant sont chacun des colorants pour solvant.

13. Le procédé de la revendication 9, dans lequel le colorant activé à la lumière de fluorescence, et le deuxième colorant sont chacun présents dans les stratifiés selon une quantité variant d'environ 0,01 à environ 2,0 % en poids.

14. Le procédé de la revendication 9, dans lequel le deuxième colorant est un colorant pour solvant comprenant au moins un colorant choisi parmi le groupe des couleurs vert, rouge, marron, noir, bleu et violet.

15. Le procédé de la revendication 9, dans lequel les stratifiés comprennent un matériau de renforcement.
